(19) Europäisches Patentamt / European Patent Office / Office européen des brevets

(11) **EP 4 443 493 A1**

(12) **EUROPEAN PATENT APPLICATION**
published in accordance with Art. 153(4) EPC

(43) Date of publication:
**09.10.2024 Bulletin 2024/41**

(21) Application number: **22898541.2**

(22) Date of filing: **21.11.2022**

(51) International Patent Classification (IPC):
*H01L 23/373* (2006.01)     *C08L 27/12* (2006.01)
*C08L 33/06* (2006.01)     *C08J 5/18* (2006.01)
*C09K 5/10* (2006.01)     *C08K 3/013* (2018.01)
*H05K 7/20* (2006.01)

(52) Cooperative Patent Classification (CPC):
**C08J 5/18; C08K 3/013; C08L 27/12; C08L 33/06;
C09K 5/10; H01L 23/373; H05K 7/20**

(86) International application number:
**PCT/JP2022/043066**

(87) International publication number:
**WO 2023/095758 (01.06.2023 Gazette 2023/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.11.2021 JP 2021193669**

(71) Applicant: **Zeon Corporation
Tokyo 100-8246 (JP)**

(72) Inventors:
• **YAMAAI ,Midori
Tokyo 100-8246 (JP)**
• **HIRANO, Takaaki
Tokyo 100-8246 (JP)**

(74) Representative: **Maiwald GmbH
Elisenhof
Elisenstraße 3
80335 München (DE)**

(54) **HEAT-CONDUCTIVE SHEET**

(57) Provided is a heat conductive sheet excellent in adhesion to metal and flame retardancy. The presently disclosed heat conductive sheet includes a fluororesin, an acrylic resin having a weight average molecular weight of not more than a predetermined value, and a heat conductive filler.

**EP 4 443 493 A1**

**Description**

TECHNICAL FIELD

The present disclosure relates to a heat conductive sheet.

BACKGROUND

In recent years, electronic parts such as integrated circuits (IC) chips, power semiconductors (IGBT module, etc.) and plasma display panels (PDPs) generate more heat along with their increasing performance. This has led to the necessity of taking measures to prevent function failure due to temperature rises in the electronic component packaging and electronic devices parts of electronic devices.

General measures to prevent function failure due to temperature rise involve attaching a heat radiator such as a metallic heat sink, radiation plate or radiation fin to a heat source such as an electronic part to facilitate heat dissipation. When a heat radiator is used, the heat radiator and the heat source are closely attached to each other via a sheet member having a high heat transfer rate (heat conductive sheet) in order to efficiently transfer heat from the heat source to the heat radiator.

Such heat conductive sheets that have been used include those formed of a composite material of resin and heat conductive filler. These heat conductive sheets are required to have excellent adhesion to the heat souse and heat radiator as well as excellent flame retardancy. Fluororesin-containing heat conductive sheets such as those described in PTL 1, for example, are considered to have high flame retardancy.

CITATION LIST

Patent Literature

PTL 1: WO2017/145954

SUMMARY

(Technical Problem)

However, application of high temperature during assembly of a package may cause deformation of the package. There is risk of heat radiation failure as this deformation causes the heat conductive sheet to be detached from the heat radiator thus resulting in poor contact between the heat conductive sheet and the heat radiator. For example, in the case of an IC package that includes a IC chip supported on a substrate, a metallic heat radiator, and a heat conductive sheet interposed between the IC chip and the metallic heat radiator, deformation of the package, such as warping of the substrate due to exposure to high temperatures, causes a stress between the IC chip and the metallic heat radiator so that the heat conductive sheet is detached from the metallic heat radiator. This results in a risk of poor contact between the heat conductive sheet and the metallic heat radiator to cause heat radiation failure. Therefore, there is room for achieving adhesion sufficient to ensure a contact between the heat conductive sheet and the metal heat radiator even when such deformation has occurred.

Accordingly, an object of the present disclosure is to provide a heat conductive sheet excellent in adhesion to metal and flame retardancy.

(Solution to Problem)

The inventor made extensive studies to achieve the foregoing object. The present inventor has established that, when a heat conductive sheet is formed of a composite material blended with a low molecular weight acrylic resin in addition to a fluororesin and a heat conductive filler, the heat conductive sheet has excellent adhesion to metal and excellent flame retardancy. Thus, the present inventor completed the present disclosure.

An object of the present disclosure is to advantageously solve the above problem, and the presently disclosed heat conductive sheet includes a fluororesin, an acrylic resin having a weight average molecular weight of 20,000 or less, and a heat conductive filler. With the presently disclosed heat conductive sheet including a fluororesin, excellent flame retardancy is imparted. With the presently disclosed heat conductive sheet including an acrylic resin having a weight average molecular weight of 20,000 or less, excellent adhesion to metal is imparted. With the presently disclosed heat conductive sheet including a heat conductive filler, excellent thermal conductivity is imparted. In the present disclosure, the weight-average molecular weight can be measured by gel permeation chromatography (GPC). Flame retardancy can be evaluated according to the method described in the Examples of the specification. Excellent adhesion to metal can be measured according to the method described in the Examples of the specification using tack to metal (adherend) as an index. Thermal conductivity can be measured according to the method described in the Examples of the specification using heat transfer rate as an index.

In the presently disclosed heat conductive sheet, it is preferable that the fluororesin include a fluororesin that is liquid at normal temperature and normal pressure. By using a fluororesin that is liquid at normal temperature and normal pressure, adhesion of the heat conductive sheet to metal is further enhanced, so that it is possible to sufficiently secure a contact between the heat conductive sheet and a metallic member such as a heat radiator even when the electronic component package or electronic device is deformed. In the present disclosure, "normal temperature" refers to 23°C and "normal pressure" refers to 1 atm (absolute pressure).

In the presently disclosed heat conductive sheet, it is preferable that the fluororesin include both a fluororesin that is liquid at normal temperature and normal pressure and a fluororesin that is solid at normal temperature and normal pressure. When the fluororesin includes a fluororesin that is solid at normal temperature and normal pressure in addition to a fluororesin that is liquid at normal temperature and normal pressure, it becomes possible for the heat conductive sheet to have excellent tack and excellent tensile strength at the same time, so that handling properties improve.

In the presently disclosed heat conductive sheet, it is preferable that the acrylic resin has a weight average molecular weight of 10,000 or less. As the weight average molecular weight of the acrylic resin decreases, adhesion to metal improves.

In the presently disclosed heat conductive sheet, it is preferable that the acrylic resin includes an acrylic resin that is liquid at normal temperature and normal pressure. By using an acrylic resin that is liquid at normal temperature and normal pressure, adhesion of the heat conductive sheet to metal further improves, so that it is possible to sufficiently secure a contact between the heat conductive sheet and a metallic member such as a heat radiator even when the electronic component package or electronic device is deformed.

In the presently disclosed heat conductive sheet, it is preferable that the acrylic resin includes a hydroxyl group. When the acrylic resin includes a hydroxyl group, adhesion to metal of the heat conductive sheet further improves.

In the presently disclosed heat conductive sheet, it is preferable that the content of the acrylic resin be 20% by mass or more and 70% by mass or less in the total resin. When the content of the acrylic resin is 20% by mass or more in the total resin, adhesion to metal of the heat conductive sheet further improves. When the content of the acrylic resin is 70% by mass or less in the total resin, the content of the fluororesin is ensured, so that sufficient flame retardancy is obtained.

It is preferable that the presently disclosed heat conductive sheet is composed of strips joined together in parallel, each strip made of a composition in which the fluororesin, the acrylic resin, and the heat conductive filler are mixed. The heat conductive sheet having such a configuration is excellent in thermal conductivity and also can be manufactured with high production efficiency.

(Advantageous Effect)

According to the present disclosure, it is possible to provide a heat conductive sheet excellent in adhesion to metal and flame retardancy.

DETAILED DESCRIPTION

The following provides a detailed description of embodiments of the present disclosure.

The presently disclosed heat conductive sheet can be used, for example, by being sandwiched between a heat source (electronic component) and a heat radiator when the heat radiator is attached to the heat source. That is, the presently disclosed heat conductive sheet can constitute, as a heat radiation member, a heat radiation device together with a heat radiator (particularly, heat radiator made of metal) such as a heat sink, a heat radiation plate, a heat spreader or a heat radiation fin. In addition, the presently disclosed heat conductive sheet can constitute an electronic component package together with a heat source (electronic component) in contact with the heat conductive sheet and with a heat radiator in contact with the heat source via the heat conductive sheet. The presently disclosed heat conductive sheet is particularly suitable for use as a heat conductive sheet interposed between an integrated circuit (IC) chip and a metallic heat radiator in an integrated circuit (IC) package. Examples of metals used for the metallic radiator include copper, iron, and aluminum.

The presently disclosed heat conductive sheet can be manufactured by any method as long as it has predetermined components and predetermined characteristics to be described later.

(Heat conductive sheet)

The presently disclosed heat conductive sheet includes a fluororesin, an acrylic resin having a weight average molecular weight of not more than a predetermined value, and a heat conductive filler. The presently disclosed heat conductive sheet may optionally further include other components such as resins other than the fluororesin and the acrylic resin, acrylic resins having a weight average molecular weight exceeding a predetermined value, and additives. With the presently disclosed heat conductive sheet including a fluororesin, excellent flame retardancy is imparted. With the presently disclosed heat conductive sheet including an acrylic resin having a weight average molecular weight of not more than a predetermined value, excellent adhesion to metal is imparted. With the presently disclosed heat conductive sheet including a heat conductive filler, excellent thermal conductivity is imparted. In the present disclosure, flame retardancy can be evaluated according to the method described in the Examples of the specification. In addition, excellent adhesion to metal can be measured according to the method described in the Examples of the specification using tack to metal (adherend) as an index. Thermal conductivity can be measured according to the method described in the Examples of the specification using heat transfer rate as an index. In the present disclosure, rubbers and elastomers are included in "resin."

<Fluororesin>

The fluororesin is an effective component for imparting excellent flame retardancy to the heat conductive sheet. In addition, the fluororesin constitutes a matrix resin of the heat conductive sheet and also functions as a binder that binds a heat conductive filler and other components in the heat conductive sheet. The fluororesin is preferable as a matrix resin of the heat conductive sheet because it is difficult to decompose at high temperatures (i.e., excellent in heat resistance) and has sufficient shape maintaining property (i.e., property that liquefaction is suppressed during manufacture of the heat conductive sheet and a certain solid shape is maintained) and flexibility. One kind of fluororesins may be used individually, or two or more kinds of fluororesins may be used in combination.

Fluororesins can be classified according to their state at normal temperature and normal pressure. Specifically, fluororesins can be classified into those that are liquid at normal temperature and normal pressure and those that are solid at normal temperature and normal pressure. From the viewpoint of obtaining better adhesion to metal, the fluororesin preferably includes at least a fluororesin that is liquid at normal temperature and normal pressure. However, when the fluororesin consists only of a fluororesin that is liquid at normal temperature and normal pressure, the strength of the heat conductive sheet tends to decrease. On the other hand, when the fluororesin includes a fluororesin that is solid at normal temperature and normal pressure in addition to a fluororesin that is liquid at normal temperature and normal pressure, it becomes possible for the heat conductive sheet to have excellent tack and excellent tensile strength at the same time, so that handling properties improve. Thus, it is more preferable that the fluororesin include both a fluororesin that is liquid at normal temperature and normal pressure and a fluororesin that is solid at normal temperature and normal pressure.

Fluororesins can also be classified into thermoplastic fluororesins and thermosetting fluororesins. Among them, thermoplastic fluororesins are preferably used. When a thermoplastic fluororesin is used, the flexibility of the heat conductive sheet can be further improved under a high-temperature environment in use (at the time of heat dissipation), so that the heat source and the heat radiator can be brought into good contact with each other via the heat conductive sheet. Further, thermosetting fluororesins may be used in combination provided that the characteristics and effects of the presently disclosed heat conductive sheet are not lost.

<Fluororesin that is liquid at normal temperature and normal pressure >

By using, as the fluororesin, a fluororesin that is liquid at normal temperature and normal pressure, adhesion to metal of the heat conductive sheet further improves, so that a contact between the heat conductive sheet and a metallic member such as a heat radiator can be sufficiently secured even when the electronic component package or the electronic device is deformed.

The fluororesin that is liquid at normal temperature and normal pressure is not particularly limited as long as it is a fluororesin that is in liquid form at normal temperature and normal pressure, and may be thermoplastic or thermosetting. From the viewpoint of improving the adhesion between the heat conductive sheet and the adherend during use of the heat conductive sheet even in a normal state (when the electronic component package or the electronic device is not deformed) to favorably radiate heat from the heat source, a thermoplastic fluororesin that is liquid at normal temperature and normal pressure is preferable.

Thermoplastic fluororesins that are liquid at normal temperature and normal pressure include, for example, vinylidene fluoride-hexafluoropropylene copolymer, vinylidene fluoride-hexafluoropentene-tetrafluoroethylene ternary copolymer, perfluoropropene oxide polymer, and tetrafluoroethylene-propylene-vinylidene fluoride copolymer.

Examples of commercially available thermoplastic fluororesins that are liquid at normal temperature and normal pressure include Viton® LM (Viton is a registered trademark in Japan, other countries, or both) manufactured by DuPont Corporation, Daiel® G-101 (Daiel is a registered trademark in Japan, other countries, or bott) (vinylidene fluoride-hexafluoropropylene copolymer) manufactured by Daikin Industries, Ltd., DYNEON FC2210 manufactured by 3M Company, and SIFEL series manufactured by Shin-Etsu Chemical Co., Ltd.

The viscosity of the fluororesin that is liquid at normal temperature and normal pressure is not particularly limited. From the viewpoint of good kneadability as well as good fluidity and excellent moldability, the viscosity (viscosity coefficient) at 80°C is preferably 500P or more and 20,000P or less, more preferably 1,000P or more and 10,000P or less.

In the present disclosure, the "viscosity (viscosity coefficient)" of a fluororesin that is liquid at normal temperature and normal pressure can be measured at a temperature of 80°C using an E-type viscometer according to the method described in the Examples of the specification.

It is noted that the molecular weight of a fluororesin that is liquid at normal temperature and normal pressure is generally smaller than the molecular weight of a fluororesin that is solid at normal temperature and normal pressure described later. As such, for example, when a fluororesin that is liquid at normal temperature and normal pressure and a fluororesin that is solid at normal temperature and normal pressure are included in the heat conductive sheet, it is common that, among two different peaks obtained by gel permeation chromatography (GPC), the peak at lower molecular weights corresponds to the fluororesin that is liquid at normal temperature and normal pressure, whereas the peak at higher molecular weights corresponds to the fluororesin that is solid at normal temperature and normal pressure.

<Fluororesin that is solid at normal temperature and normal pressure>

The fluororesin that is solid at normal temperature and normal pressure is not particularly limited as long as it is a fluororesin that is in solid form at normal temperature and normal pressure and may be thermoplastic or thermosetting. From the viewpoint of ensuring good adhesion between the heat conductive sheet and the adherend even in a normal state (when the electronic component package or the electronic device is not deformed), a thermoplastic fluororesin that is solid at normal temperature and normal pressure is preferable.

Examples of thermoplastic fluororesins that are solid at normal temperature and normal pressure include elastomers obtained by polymerizing fluorine-containing monomers, such as vinylidene fluoride fluororesin, tetrafluoroethylene-propylene fluororesin, and tetrafluoroethylene-perfluorovinyl ether fluororesin. More specific examples thereof include polytetrafluoroethylene, tetrafluoroethylene-perfluoroalkyl vinyl ether copolymer, tetrafluoroethylene-hexafluoropropylene copolymer, tetrafluoroethylene-ethylene copolymer, polyvinylidene fluoride, polychlorotrifluoroethylene, ethylene-chlorofluoroethylene copolymer, tetrafluoroethylene-perfluorodioxole copolymer, polyvinyl fluoride, tetrafluoroethylene-propylene copolymer, vinylidene fluoride-hexafluoropropylene copolymer, vinylidene fluoride-tetrafluoro ethylene-hexafluoropropylene copolymer, acrylic modified polytetrafluoroethylene, ester modified polytetrafluoroethylene, epoxy modified polytetrafluoroethylene, and silane modified polytetrafluoroethylene. Of these, vinylidene fluoride-hexafluoropropylene copolymers are preferred from the viewpoint of processability.

Examples of commercially available thermoplastic fluororesins that are solid at normal temperature and pressure include Daiel® G-912, G-700 series Daiel G-550 series /G-600 series, Daiel G-310 manufactured by Daikin Industries, Inc.; KYNAR® (KYNAR is a registered mark in Japan, other countries, or both) series and KYNAR FLEX® (KYNAR FLEX is a registered mark in Japan, other countries, or both) series manufactured by ARKEMA Co., Ltd.; DYNEON FC2211, FPO3600ULV manufactured by 3M Company; and Viton® A-100, A-200, A-500 series manufactured by The Chemours Company.

Note that the Moony viscosity ($ML_{1+4}$, 100°C) of the fluororesin that is solid at normal temperature and normal pressure is preferably 3.5 or more, more preferably 10 or more, still more preferably 20 or more, and preferably 120 or less, more preferably 100 or less, still more preferably 70 or less, even more preferably 50 or less, particularly preferably 30 or less.

In the present disclosure, "Mooney viscosity ($ML_{1+4}$, 100°C)" can be measured at 100°C in compliance with JIS K6300 according to the method described in the Examples of the specification.

<Proportion of fluororesin in total resin>

The proportion of the fluororesin in the total resin included in the heat conductive sheet is not particularly limited, but is preferably 30% by mass or more, and more preferably 60% by mass or more, from the viewpoint of imparting excellent flame retardancy to the heat conductive sheet and ensuring shape maintaining property at the time of forming the heat conductive sheet. In addition, the proportion of the fluororesin in the total resin included in the heat conductive sheet is preferably 80% by mass or less, and more preferably 75% by mass or less, from the viewpoint of ensuring the content ratio of the acrylic resin to impart excellent adhesion to metal to the heat conductive sheet.

<Proportion of fluoropolymer that is liquid at normal temperature and normal pressure in total resin>

The proportion of the fluororesin that is liquid at normal temperature and normal pressure in total resin included in the heat conductive sheet (i.e., the ratio of the amount of the fluororesin that is liquid at normal temperature and normal pressure in the total amount of the fluororesin that is liquid at normal temperature and normal pressure and the fluororesin that is solid at normal temperature and normal pressure) is not particularly limited, but is preferably 30% by mass or more, more preferably 50% by mass or more, and still more preferably 60% by mass or more, from the viewpoint of imparting excellent adhesion to metal to the heat conductive sheet. Further, the proportion of the fluororesin that is liquid at normal temperature and normal pressure in the fluororesin is preferably 90% by mass or less, more preferably 80% by mass or less, and still more preferably 75% by mass or less, from the viewpoint of improving handling properties because the heat conductive sheet can have both tack and tensile strength by including the fluororesin that is solid at normal temperature and normal pressure.

<Acrylic resin having a weight average molecular weight of not more than a predetermined value>

The acrylic resin having a weight average molecular weight of not more than a predetermined value (hereinafter also referred to as "low molecular weight acrylic resin") is an effective component for imparting excellent adhesion to metal to the heat conductive sheet. By using a low molecular weight acrylic resin among acrylic resins, tack is imparted to the heat conductive sheet, so that excellent adhesion to metal can be achieved.

The term "acrylic resin" refers to a polymer including, as a repeating unit, a (meth)acrylic acid ester monomer unit and optionally repeating unit(s) other than a (meth)acrylic acid ester monomer unit (hereinafter referred to as "other repeating units"). Note that in the present disclosure, "(meth)acryl" is used to indicate "acryl" and/or "methacryl."

From the viewpoint of further enhancing adhesion to metal of the heat conductive sheet, the low molecular weight acrylic resin preferably includes a acrylic resin that is liquid at normal temperature and normal pressure. Examples of commercially available acrylic resins that are liquid at normal temperature and normal pressure include "ARUFON UP-1000", "ARUFON UP-1010", "ARUFON UP-1020", "ARUFON UP-1021", "ARUFON UP-1061", "ARUFON UP-1080", "ARUFON UP-1110", "ARUFON UP-1170", "ARUFON UP-1000", "ARUFON UP-1190", "ARUFON UP-1500", "ARUFON UH-2000", "ARUFON UH-2041", "ARUFON UH-2190", "ARUFON UC-3510", "ARUFON UG-4010", "ARUFON US-6100" and "ARUFON US-6170" (TOAGOSEI Co., Ltd.); and "Act Flow UT-1001, UMM-1001" (Soken Chemical & Engineering Co., Ltd).

The low molecular weight acrylic resin may optionally include a functional group. Examples of functional groups include hydroxyl group, carboxy group, epoxy group, long-chain alkyl group, and alkoxysilyl group. When the low molecular weight acrylic resin includes a functional group, the low molecular weight acrylic resin may include one functional group or two or more different functional groups. As such functional groups, those that further improve the effect of the present disclosure are preferable. For example, functional groups that impart high viscosity to the low molecular weight acrylic resin are preferable. From the viewpoint of imparting high viscosity to the low molecular weight acrylic resin as described above, the low molecular weight acrylic resin preferably includes a hydroxyl group. When the low molecular weight acrylic resin includes a hydroxyl group, the hydroxyl value of the low molecular weight acrylic resin is preferably 20 mg·KOH/g resin or more, more preferably 30 mg·KOH/g resin or more, and preferably 120 mg·KOH/g resin or less, more preferably 80 mg·KOH/g resin or less. Because a low molecular weight acrylic resin including a hydroxyl group has a high viscosity, high tack and hence better adhesion to metal can be imparted to the heat conductive sheet better, and further, excellent tack and tensile strength can be achieved at the same time thus improving handling properties.

«(Meth)acrylic acid ester monomer unit»

Examples of (meth)acrylic acid ester monomers that may form a (meth)acrylic acid ester monomer unit include: acrylic acid alkyl esters such as methyl acrylate, ethyl acrylate, n-propyl acrylate, isopropyl acrylate, n-butyl acrylate, t-butyl acrylate, isobutyl acrylate, n-pentyl acrylate, isopentyl acrylate, hexyl acrylate, heptyl acrylate, octyl acrylate, 2-ethylhexyl acrylate, nonyl acrylate, decyl acrylate, lauryl acrylate, n-tetradecyl acrylate, and stearyl acrylate; methacrylic acid alkyl esters such as methyl methacrylate, ethyl methacrylate, n-propyl methacrylate, isopropyl methacrylate, n-butyl methacrylate, t-butyl methacrylate, isobutyl methacrylate, n-pentyl methacrylate, isopentyl methacrylate, hexyl methacrylate, heptyl methacrylate, octyl methacrylate, 2-ethylhexyl methacrylate, nonyl methacrylate, decyl methacrylate, lauryl methacrylate, n-tetradecyl methacrylate, and stearyl methacrylate; derivatives obtained by substituting the foregoing monomers so as to include the above-mentioned functional group(s); and so forth. Among them, monomers selected from methyl acrylate, ethyl acrylate, n-butyl acrylate, 2-ethylhexyl acrylate, methyl methacrylate, ethyl methacrylate, n-butyl methacrylate, and 2-ethylhexyl methacrylate, or derivatives obtained by substituting the monomers so as to include a hydroxyl group are preferable, with monomers selected from n-butyl acrylate, ethyl methacrylate, and 2-ethylhexyl acrylate, or derivatives obtained by substituting the monomers so as to include a hydroxyl group being more preferable.

One of these monomers may be used individually, or two or more of these monomers may be used in combination.

<<Other repeating units>>

"Other repeating units" that may be included in the low molecular weight acrylic resin are not particularly limited, and examples thereof include monomer units having the functional group (e.g., hydroxyl group) described above, an aromatic vinyl monomer unit, a nitrile group-containing monomer unit, a conjugated diene monomer unit, and an alkylene structure unit.

-Monomer units having a hydroxyl group-

Examples of monomer units having the functional group described above include monomer units having a hydroxyl group. Monomers having a hydroxyl group that may form a monomer unit having a hydroxyl group include: ethylenically unsaturated alcohols such as (meth)allyl alcohol, 3-butene-1-ol, and 5-hexene-1-ol; alkanol esters of ethylenically unsaturated carboxylic acids, such as 2-hydroxyethyl acrylate, 2-hydroxypropyl acrylate, 2-hydroxyethyl methacrylate, 2-hydroxypropyl methacrylate, di-2-hydroxyethyl maleate, di-4-hydroxybutyl maleate, and di-2-hydroxypropyl itaconate; esters of polyalkylene glycol and (meth)acrylic acid represented by the general formula: $CH_2=CR^Z-COO-(C_nH_{2n}O)_m-H$ (where m is an integer of 2 to 9, n is an integer of 2 to 4, and $R^z$ represents hydrogen or methyl group; mono(meth)acrylic acid esters of dihydroxy esters of dicarboxylic acids, such as 2-hydroxyethyl-2'-(meth)acryloyloxyphthalate and 2-hydroxyethyl-2'-(meth)acryloyloxysuccinate; vinyl ethers such as 2-hydroxyethyl vinyl ether and 2-hydroxypropyl vinyl ether; mono(meth)allyl ethers of alkylene glycols, such as (meth)allyl-2-hydroxyethyl ether, (meth)allyl-2-hydroxypropyl ether, (meth)allyl-3-hydroxypropyl ether, (meth)allyl-2-hydroxybutyl ether, (meth)allyl-3-hydroxybutyl ether, (meth)allyl-4-hydroxybutyl ether, and (meth)allyl-6-hydroxyhexyl ether; polyoxyalkylene glycol mono(meth)allyl ethers such as diethylene glycol mono(meth)allyl ether and dipropylene glycol mono(meth)allyl ether; mono(meth)allyl ethers of halogen and hydroxy substituted (poly)alkylene glycol, such as glycerin mono(meth)allyl ether, (meth)allyl-2-chloro-3-hydroxypropyl ether, and (meth)allyl-2-hydroxy-3-chloropropyl ether; mono(meth)allyl ethers of polyhydric phenols such as eugenol and isoeugenol and their halogen-substituted products; (meth)allyl thioethers of alkylene glycols, such as (meth)allyl-2-hydroxyethyl thioether and (meth)allyl-2-hydroxypropyl thioethers; and so forth.

-Aromatic vinyl monomer unit-

Examples of aromatic vinyl monomers that may form an aromatic vinyl monomer unit include styrene, α-methylstyrene, butoxystyrene, and vinylnaphthalene. Of these aromatic vinyl monomers, styrene is preferable.

One of these monomers may be used individually, or two or more of these monomers may be used in combination.

-Nitrile group-containing monomer unit -

Examples of nitrile group-containing monomers that may form a nitrile group-containing monomer unit include α,β-ethylenically unsaturated nitrile monomers. Specifically, any α,β-ethylenically unsaturated compound that has a nitrile group can be used as an α,β-ethylenically unsaturated nitrile monomer without any specific limitations. Examples thereof include acrylonitrile; α-halogenoacrylonitriles such as α-chloroacrylonitrile and α-bromoacrylonitrile; and α-alkylacrylonitriles such as methacrylonitrile and α-ethylacrylonitrile. Of these examples, acrylonitrile and methacrylonitrile are preferable, and acrylonitrile is more preferable as a nitrile group-containing monomer.

One of these monomers may be used individually, or two or more of these monomers may be used in combination.

-Conjugated diene monomer unit -

Examples of conjugated diene monomers that may form a conjugated diene monomer unit include conjugated diene compounds having 4 or more carbon atoms, such as 1,3-butadiene, isoprene, 2,3-dimethyl-1,3-butadiene, and 1,3-pentadiene. Of these conjugated diene monomers, 1,3-butadiene is preferable.

-Alkylene structural unit-

The alkylene structural unit is a repeating unit composed only of an alkylene structure represented by the formula: $-C_nH_{2n}-$ [where n is an integer of 2 or more].

Methods for introducing the alkylene structural unit into the low molecular weight acrylic resin are not particularly limited. For example, the following method (1) or (2) may be used:

(1) Converting a conjugated diene monomer unit into an alkylene structural unit by preparing a copolymer from a monomer composition containing a conjugated diene monomer (e.g., 1,3 -butadiene, isoprene, 2,3-dimethyl-1,3-butadiene, 1,3-pentadiene) and hydrogenating the copolymer; and
(2) Preparing a copolymer from a monomer composition containing a 1-olefin monomer (e.g., ethylene, propylene, 1-butene, 1-hexene).

Of these methods, the method (1) is preferable in terms of ease of production of the low molecular weight acrylic resin.

<Weight average molecular weight of low molecular weight acrylic resin>

The weight average molecular weight of the acrylic resin having a weight average molecular weight of not more than a predetermined value (low molecular weight acrylic resin) is 20,000 or less and may be preferably 10,000 or less, more preferably 9,000 or less, still more preferably 8,000 or less, and even more preferably 7,000 or less. When such an acrylic resin having a low weight average molecular weight is used as the acrylic resin, tack is imparted to the presently disclosed heat conductive sheet, so that excellent adhesion to metal can be achieved. In addition, the weight average molecular weight of the low molecular weight acrylic resin may be, for example, 200 or more, preferably 500 or more, more preferably 700 or more, still more preferably 1,000 or more, even more preferably 1,500 or more, further preferably 2,000 or more, and still further preferably 2,500 or more, in order to ensure resin properties (e.g., viscosity, binding property to heat conductive filler).

<Glass transition temperature of low molecular weight acrylic resin>

The glass transition temperature (Tg) of the low molecular weight acrylic resin is not particularly limited but is preferably a glass transition temperature at which the low molecular weight acrylic resin becomes liquid at normal temperature and normal pressure. When the low molecular weight acrylic resin is liquid at normal temperature and normal pressure, viscosity is imparted to the low molecular weight acrylic resin, and as a result, high tack is imparted to the heat conductive sheet, so that it is possible to impart better adhesion to metal. Such a glass transition temperature is preferably -80°C or higher, more preferably -70°C or higher, still more preferably -60°C or higher, and preferably 0°C or lower, more preferably -10°C or lower, still more preferably -30°C or lower.

<Viscosity of low molecular weight acrylic resin>

When the low-molecular weight acrylic resin is liquid at normal temperature and normal pressure, the viscosity of the low-molecular weight acrylic resin is not particularly limited. Because it is possible to impart high viscosity and hence better adhesion to metal to the heat conductive sheet and also allow the heat conductive sheet to have excellent tack and excellent tensile strength at the same time to improve handing properties, the viscosity of the low-molecular weight acrylic resin at 25°C is preferably 3,000 mPa·s or more, more preferably 5,000 mPa·s or more, still more preferably 10,000 mPa·s or more. The viscosity of the low molecular weight acrylic resin is preferably 1,000,000 mPa·s or less, more preferably 800,000 mPa·s or less, still more preferably 500,000 mPa·s or less, from the viewpoint of ensuring the shape-maintaining property at the time of forming the heat conductive sheet. In the present disclosure, the "viscosity" of the low molecular weight acrylic resin can be measured at a temperature of 25°C using an E-type viscometer.

<Proportion of low molecular weight acrylic resin in total resin>

The proportion of the low molecular weight acrylic resin in the total resin included in the heat conductive sheet is not particularly limited, but is preferably 20% by mass or more, and more preferably 25% by mass or more, from the viewpoint of imparting excellent adhesion to metal to the heat conductive sheet. The proportion of the low molecular weight acrylic resin in the total resin included in the heat conductive sheet is preferably 70% by mass or less, and more preferably 50% by mass or less, from the viewpoint of ensuring the content ratio of the fluororesin so as to impart excellent flame retardancy to the heat conductive sheet and ensure the shape maintaining property at the time of forming the heat conductive sheet.
When the heat conductive sheet includes two or more different low molecular weight acrylic resins, the amount of the low molecular weight acrylic resin refers to the sum of the amounts of the low molecular weight acrylic resins.
For example, when two or more peaks having a weight-average molecular weight not more than a predetermined value are detected by GPC, the peak area of each peak can correspond to the amount of each low molecular weight acrylic resin, and the sum of these peak areas can be regarded as the amount (total amount) of the low molecular weight acrylic resin.

In addition, when the heat conductive sheet includes both one or more low molecular weight acrylic resins and one or more acrylic resins having a weight average molecular weight exceeding a predetermined value, the content of the low molecular weight acrylic resin can be determined as follows: among the peaks detected by GPC, the sum of the peak areas of the peaks corresponding to the acrylic resin having a weight average molecular weight of not more than a predetermined value is regarded as the amount of the low molecular weight acrylic resin, with the peak area of the peak corresponding to the acrylic resin having a weight average molecular weight exceeding a predetermined value being excluded from the amount of the low molecular weight acrylic resin.

<Method for preparing low molecular weight acrylic resin>

Methods for preparing the low molecular weight acrylic resin described above are not particularly limited. The low molecular weight acrylic resin can be prepared for example by polymerizing a monomer composition containing the above-described monomers to obtain a polymer, and then hydrogenating the polymer as necessary. In addition, when the low molecular weight acrylic resin includes the above-mentioned functional group, the low molecular weight acrylic resin may be prepared by performing polymerization using a derivative substituted with the above-mentioned functional group as a monomer, or may be prepared by performing polymerization using unsubstituted monomers and then substituting the polymer with the above-mentioned functional group.

The content ratio of each monomer in the monomer composition used for preparing the low molecular weight acrylic resin can be determined in accordance with the content ratio of each repeating unit in the low molecular weight acrylic resin.

The polymerization method is not specifically limited, and any of solution polymerization, suspension polymerization, bulk polymerization, and emulsion polymerization may be used. Moreover, ionic polymerization, radical polymerization, living radical polymerization, or the like may be adopted as the polymerization reaction.

When a molecular weight regulator is used in preparing the low molecular weight acrylic resin, the amount of the molecular weight regulator is preferably less than 0.5 parts by mass with respect to 100 parts by mass of the total of the monomers.

<Heat conductive filler>

The heat conductive filler is an effective component for imparting excellent thermal conductivity to the heat conductive sheet. The heat conductive filler constituting the heat conductive sheet is not particularly limited, and for example, particulate materials such as alumina particles, zinc oxide particles, inorganic nitride particles, silicon carbide particles, magnesium oxide particles, and particulate carbon materials; and fibrous materials such as carbon nanotubes, vapor-grown carbon fibers, carbon fibers obtained by carbonizing organic fibers, and cut products thereof can be used. Among them, as the heat conductive filler, it is preferable to use at least one selected from the group consisting of inorganic nitride particles and particulate carbon materials, and fibrous carbon nanomaterials such as carbon nanotubes (CNTs).

One kind of these heat conductive fillers may be used alone, or two or more kinds thereof may be used in combination.

The amount of the heat conductive filler included in the heat conductive sheet is not particularly limited, and may be, for example, preferably 5 parts by mass or more, more preferably 50 parts by mass or more, still more preferably 70 parts by mass or more, and preferably 200 parts by mass or less, more preferably 160 parts by mass or less, still more preferably 140 parts by mass or less, per 100 parts by mass of the total resin.

<<Inorganic nitride particles>>

Examples of the inorganic nitride particles include boron nitride particles, aluminum nitride particles, and silicon nitride particles. These may be used alone one, two or more may be used in combination in any ratio.

Among these, boron nitride particles are preferable from the viewpoint of imparting electrical insulation and thermal conductivity to the heat conductive sheet.

Specific examples of commercially available products of boron nitride particles include "PT" series (e.g., "PT-110") manufactured by Momentive Performance Materials Japan LLC; "SHOBN UHP" series (e.g., SHOBN UHP-1) manufactured by Showa Denko K.K.; "HSL" and "HS" manufactured by Dangdong Chemical Engineering Institute Co., Ltd.; and so forth.

<Particulate carbon material>

The particulate carbon material is not particularly limited, and for example, graphite such as artificial graphite, scaly graphite, slice graphite, natural graphite, acid-treated graphite, expandable graphite, and expanded graphite; carbon black; and the like can be used. These may be used alone one, or two or more may be used in combination in any ratio.

Among them, expanded graphite is preferable. When expanded graphite is used, the thermal conductivity of the heat conductive sheet can be further improved.

Expanded graphite may be obtained, for example, by thermal expansion of expandable graphite which has been obtained by chemical treatment of graphite such as flake graphite with sulfuric acid or the like, followed by micronization. Examples of the expanded graphite include EC1500, EC1000, EC500, EC300, EC100, EC50 (all trade names) manufactured by Ito Graphite Co., Ltd., and CS-5, CS-30, CS-100, CS-F400 manufactured by MARUTOYO Co., Ltd.

When the heat conductive filler is a particle carbon material, the content ratio of the particulate carbon material in the heat conductive filler is preferably 40% by mass or more, more preferably 50% by mass or more, and preferably 100% by mass or less. When the content ratio of the particulate carbon material is equal to or higher than the lower limit value, the heat transfer path can be formed satisfactorily, and thus the thermal conductivity of the heat conductive sheet can be further increased. In addition, when the content ratio of the particle carbon material is equal to or less than the above upper limit value, it is possible to suppress a decrease in the flexibility of the heat conductive sheet due to the inclusion of the particulate carbon material, so that adhesion between the heat conductive sheet and the adherend (heat source, heat radiator) is increased, allowing the heat conductive sheet to exert excellent thermal conductivity.

-Orientation of particulate carbon material-

The orientation of the particle carbon material in the heat conductive sheet is preferably such that the angle of the particulate carbon material with respect to the surface of the heat conductive sheet in the longitudinal direction (hereinafter, sometimes referred to as the "orientation angle of the particulate carbon material") is 60° or more and 90° or less. Further, the orientation angle of the particulate carbon material is more preferably 65° or more, still more preferably 70° or more, and preferably 90° or less. When the orientation angle of the particulate carbon material is within the predetermined range, the thermal resistance of the heat conductive sheet can be reduced to increase the thermal conductivity. In the present disclosure, the "orientation of the particulate carbon material" can be measured according to the method described in the Examples of the specification.

-Average particle diameter of particulate carbon material-

The volume average particle diameter of the particulate carbon material is preferably 0.1 $\mu$m or more, more preferably 1 $\mu$m or more, preferably 300 $\mu$m or less, and more preferably 250 $\mu$m or less. When the volume average particle diameter of the particulate carbon material is within the above range, the thermal conductivity of the heat conductive sheet can be improved. The volume-average particle diameter can be measured using a laser diffraction/scattering particle size analyzer (LA-960 Series, manufactured by Horiba, Ltd.).

Further, the average particle diameter of the particulate carbon material in the longitudinal direction is preferably 30 $\mu$m or more, more preferably 50 $\mu$m or more, and preferably 300 $\mu$m or less, more preferably 200 $\mu$m or less. The average particle diameter of the particulate carbon material in the minor axis direction is preferably 5 $\mu$m or more, more preferably 10 $\mu$m or more, and preferably 30 $\mu$m or less, more preferably 20 $\mu$m or less. When the average particle diameter of the particulate carbon material is within the above range, the thermal conductivity of the heat conductive sheet can be improved. In the specification, the "average particle diameter" can be obtained by observing the particulate carbon material with a SEM (scanning electron microscope), measuring the maximum diameter (major diameter) and the minimum diameter (minor diameter) for any 50 particulate carbon materials, and calculating the number average of the measured major diameter and minor diameter.

-Content ratio of particulate carbon material-

The content ratio of the particulate carbon material is preferably 20 parts by mass or more, more preferably 30 parts by mass or more, still more preferably 50 parts by mass or more, and preferably 150 parts by mass or less, more preferably 130 parts by mass or less, still more preferably 120 parts by mass or less, per 100 parts by mass of the total resin. When the content ratio of the particulate carbon material is 20 parts by mass or more and 150 parts by mass or less per 100 parts by mass of the total resin, the balance between hardness and adhesion of the heat conductive sheet can be improved, so that handleability can be improved. When the content ratio of the particulate carbon material is 30 parts by mass or more per 100 parts by mass of the total resin, the heat transfer rate of the heat conductive sheet can be increased. Further, when the content ratio of the particle carbon material is 100 parts by mass or less per 100 parts by mass of the total resin, tack of the heat conductive sheet can be improved, so that powder fall of the particulate carbon material can be sufficiently prevented.

<Fibrous material>

The fibrous carbon nanomaterial containing CNTs, which can be suitably used as the fibrous material, may consist only of CNTs, or may be a mixture of CNTs and a fibrous carbon nanomaterial other than CNTs.

The CNTs included in the fibrous carbon nanomaterial are not specifically limited and may be single-walled carbon nanotubes and/or multi-walled carbon nanotubes. However, the CNTs are preferably carbon nanotubes having 1 to 5 walls, more preferably single-walled carbon nanotubes.

Further, the fibrous carbon nanomaterial described above is not particularly limited. It is preferable to use a fibrous carbon nanomaterial that includes CNTs produced in accordance with the super growth method (see WO2006/011655) wherein when synthesizing CNTs by chemical vapor deposition (CVD) by supplying a raw material compound and a carrier gas onto a substrate having a catalyst layer for CNT production on the surface, a trace amount of an oxidizing agent (catalyst activating material) is allowed to exist in the system to thereby dramatically improve the catalytic activity of the catalyst layer. Hereinafter, carbon nanotubes obtained by the super growth method may also be referred to as "SGCNTs."

The fibrous carbon nanomaterial including SGCNTs produced by the super growth method may be composed of only SGCNTs, or may include, in addition to SGCNTs, other carbon nanostructures such as non-cylindrical carbon nanostructures.

When the heat conductive filler includes a fibrous material, the content ratio of the fibrous material in the heat conductive filler is preferably 0.001% by mass or more, more preferably 0.005% by mass or more, and preferably 20% by mass or less, more preferably 10% by mass or less. When the content ratio of the fibrous material is equal to or higher than the lower limit value, the heat transfer path can be formed satisfactorily, and thus the heat conductivity of the heat conductive sheet can be further increased. In addition, when the content ratio of the fibrous material is equal to or less than the above upper limit value, it is possible to suppress a decrease in the flexibility of the heat conductive sheet due to the inclusion of the fibrous material to enhance the adhesion between the heat conductive sheet and the adherend (heat source, heat radiator), allowing the heat conductive sheet to exert excellent thermal conductivity.

<Other components>

The presently disclosed heat conductive sheet may further optionally include other components in addition to the above-described fluororesin, acrylic resin having a weight average molecular weight of not more than a predetermined value and heat conductive filler. Examples of other components include resins other than fluororesins and acrylic resins (hereinafter referred to as "other resins"), acrylic resins having a weight average molecular weight exceeding a predetermined value, additives, and fillers.

<<Other resins>>

Other resins that can be used include those known in the art, such as epoxy resins and silicone resins. One kind of these resins may be used individually, or two or more kinds of them may be used in combination.

<Acrylic resin having a weight average molecular weight exceeding a predetermined value>

In addition to the acrylic resin having a weight average molecular weight of not more than a predetermined value, the presently disclosed heat conductive sheet may optionally further include an acrylic resin having a weight average molecular weight exceeding a predetermined value. The "acrylic resin having a weight average molecular weight exceeding a predetermined value" refers to an acrylic resin having a weight average molecular weight exceeding the upper limit of the weight average molecular weight defined in the "acrylic resin having a weight average molecular weight of not more than a predetermined value" (low molecular weight acrylic resin) described above, and may be, for example, an acrylic resin having a weight average molecular weight of more than 20,000. The "acrylic resin" is as described in the section titled "acrylic resin having a weight average molecular weight of not more than a predetermined value."

<<Additives>>

Examples of additives that can be included into the heat conductive sheet include, but are not limited to, flame retardants such as red phosphorus-based flame retardants and phosphoric acid ester-based flame retardants; hygroscopic agents; adhesion improvers such as silane coupling agents, titanium coupling agents, and acid anhydrides; wettability improvers such as nonionic surfactants and fluorine-based surfactants; and ion trapping agents such as inorganic ion exchangers. One kind of these additives above may be used individually, or two or more kinds of these additives may be used in combination. In addition to the heat conductive filler, resin particles, rubber particles and the like may be blended for the purpose of improving the strength, compression ratio and the like of the heat conductive sheet.

<Method for forming heat conductive sheet>

The presently disclosed heat conductive sheet can be formed by any method, e.g., through a pre-heat conductive sheet forming step, a laminate forming step, a slicing step, and the like according to the method described in WO2016/185688.

<Pre-heat conductive sheet forming step>

In the pre-heat conductive sheet forming step, all the components forming the heat conductive sheet, that is, a composition containing the fluororesin, acrylic resin having a weight average molecular weight of not more than a predetermined value, heat conductive filler, and optionally other components are pressed into a sheet to form a pre-heat conductive sheet.

[Composition]

The composition can be prepared by mixing all the components forming the heat conductive sheet, i.e., the fluororesin, acrylic resin having a weight average molecular weight of not more than a predetermined value, heat conductive filler, and optionally other components.

Mixing of the above-described components is not particularly limited and can be carried out using a mixing device known in the art, such as a kneader, a roll, or a mixer. Mixing may optionally be carried out in the presence of a solvent such as an organic solvent. Mixing time may be, for example, 5 minutes or more and 60 minutes or less. Mixing temperature may be, for example, 5° C or above and 150°C or below.

[Shaping of composition]

The composition prepared as described above can then be shaped into a sheet by pressing (primary pressing), optionally after defoaming, removal of solvent optionally used, and crushing.

The composition can be shaped into a sheet by any shaping method known in the art as long as pressure is applied. For example, press molding, rolling molding, or extrusion molding can be used. In particular, it is preferred that the composition is shaped into a sheet by rolling, more preferably by passing the composition between rolls with the composition sandwiched between protection films. The protective film is not particularly limited, and a polyethylene terephthalate (PET) film subjected to sand blasting treatment or the like can be used. The roll temperature may be 5°C or above and 150°C or below.

[Pre-heat conductive sheet]

The thickness of the pre-heat conductive sheet formed by pressing the composition into a sheet is not particularly limited, and may be, for example, 0.05mm or more and 2mm or less.

<Laminate forming step>

In the laminate forming step, a laminate is obtained either by laminating on top of each other pre-heat conductive sheets obtained in the pre-heat conductive sheet forming step, or by folding or rolling the pre-heat conductive sheet.

In the laminate obtained in the laminate forming step, by further increasing the adhesion between the surfaces of the pre-heat conductive sheet, in order to sufficiently suppress delamination of the laminate, the laminate forming step may be performed in a state in which the surface of the pre-heat conductive sheet is slightly dissolved in a solvent, or the laminate forming step may be performed in a state in which an adhesive is applied to the surface of the pre-heat conductive sheet or in a state in which an adhesive layer is provided on the surface of the pre-heat conductive sheet, or the laminate in which the pre-heat conductive sheet is laminated may be further thermally pressed (secondary pressing) in the laminating direction.

From the viewpoint of efficiently suppressing delamination, it is preferable to perform secondary pressing to the obtained laminate in the lamination direction. The secondary pressing is not particularly limited and may be performed at a pressure 0.05 MPa or more and 0.5MPa or less in the lamination direction, at a temperature of 20°C or above and 170°C or below for 10 seconds to 30 minutes.

In the laminate obtained by laminating, folding or winding the primary sheet, it is presumed that the heat conductive filler is oriented in a direction substantially orthogonal to the lamination direction. For example, when the heat conductive filler is a particulate carbon material and the shape thereof is a scaly shape, it is presumed that the direction of the major axis of the major surface of the scaly shape is substantially orthogonal to the stacking direction.

«Slicing step»

In the slicing step, the laminate obtained in the laminate forming step is sliced at an angle of 45° or less relative to the lamination direction to provide a heat conductive sheet formed of a sliced piece of the laminate. Any method can be used to slice the laminate, e.g., multi-blade method, laser processing method, water jet method, or knife processing method can be used, with the knife processing method being preferred because the thickness of the heat conductive sheet can be easily made uniform. Any cutting tool can be used to slice the laminate, e.g., a slicing member which has a smooth disk surface with a slit and a blade protruding from the slit (e.g., a plane or slicer equipped with a sharp blade) can be used.

The heat conductive sheet obtained through the slicing step usually has a structure in which strips (sliced pieces of the pre-heat conductive sheet constituting the laminate) including the fluororesin, acrylic resin having a weight average molecular weight of not more than a predetermined value, and heat conductive filler are joined in parallel.

From the perspective of increasing the heat conductivity of the heat conductive sheet, the angle at which the laminate is sliced is preferably 30° or less relative to the lamination direction, more preferably 15° or less relative to the lamination direction, even more preferably substantially 0° relative to the lamination direction (i.e., along the lamination direction).

In the secondary sheet thus obtained, the heat conductive filler is well oriented in the thickness direction, and the angle of the heat conductive filler with respect to the sheet surface in the longitudinal direction is 60° or more and 90° or less. More specifically, when the heat conductive filler is a particulate carbon material having a scaly shape, the angle is 60° or more and 90° or less with respect to the sheet surface in the direction of the long axis of the main surface of the scaly shape.

Further, from the viewpoint of easily slicing the laminate, the temperature of the laminate at the time of slicing is preferably -20°C or above and 30°C or below. For the same reason, the laminate is preferably sliced while applying a pressure in a direction perpendicular to the lamination direction, more preferably while applying a pressure of 0.1 MPa to 0.5 MPa in a direction perpendicular to the lamination direction.

In the heat conductive sheet obtained through the various steps described above, the heat conductive filler is well oriented in the thickness direction. For example, when the heat conductive filler is a particulate carbon material and the shape is a scaly shape, the direction of the major axis of the major surface of the scaly shape substantially coincides with the thickness direction of the secondary sheet.

<Properties of heat conductive sheet>

<Tack>

The presently disclosed heat conductive sheet exhibits excellent measurements of tack to metal. The measured value of tack with respect to metal (e.g., metallic radiator) serves as an index of adhesion to metal. The larger the measured value of tack with respect to metal, the better the adhesion to metal. The measured tack is, for example, preferably 20 N/cm$^2$ or more, more preferably 25 N/cm$^2$ or more, preferably 200 N/cm$^2$ or less, and more preferably 100 N/cm$^2$ or less. In the present disclosure, "tack to metal" can be measured according to the method described in the Examples of the specification.

<Tensile strength>

The presently disclosed heat conductive sheet exhibits excellent measurements of tensile strength. Tensile strength is an index of durability, and the higher the tensile strength, the better the durability. The heat conductive film preferably has a tensile strength of, for example, 0.01 MPa or higher, more preferably 0.02 MPa or higher, preferably 3.00 MPa or lower, and more preferably 2 MPa or lower. When the tensile strength is equal to or higher than the lower limit, sufficient strength (durability) can be ensured. In addition, when the tensile strength is equal to or lower than the above upper limit value, the heat conductive sheet can be easily manufactured. In the present disclosure, the "tensile strength" can be measured according to the method described in the Examples of the specification.

Heat transfer rate

The presently disclosed heat conductive sheet exhibits excellent measurements of heat transfer rate. For example, the heat transfer rate of the heat conductive film at 25°C in the thickness direction is preferably 1 W/m·K or more, more preferably 5 W/m·K or more, still more preferably 10 W/m K or more. Heat transfer rate is an index of thermal conductivity, and the higher the heat transfer rate, the better the thermal conductivity for favorably transferring heat from the heat source to the heat radiator. In the present disclosure, "heat transfer rate" can be measured according to the method described in the Examples of the specification.

<Flame retardancy>

The presently disclosed heat conductive sheet exhibits excellent performance with respect to flame retardancy. In the present disclosure, "flame retardancy" can be evaluated according to the method described in the Examples of the specification.

EXAMPLES

The following provides a more specific description of the present disclosure based on examples. However, the present disclosure is not limited to the following examples. In the following description, "%" and "parts" used in expressing quantities are by mass, unless otherwise specified.
In Examples and Comparative Examples, the viscosity of the resin that is liquid at normal temperature and normal pressure; the Mooney viscosity of the resin that is solid at normal temperature and normal pressure; and the tack to metal (adherend), tensile strength, heat transfer rate, and flame retardancy of the heat conductive sheet were measured or evaluated according to the methods described below.

(Methods for measurement or evaluation)

<Viscosity of resin that is liquid at normal temperature and normal pressure>

The viscosity (viscosity coefficient: P) of the fluororesin that is liquid at normal temperature and normal pressure was measured at 80°C using an E-type viscometer ("BROOKFIELD DIGITAL VISCOMETER MODEL DV-II Pro" manufactured by BROOKFIELD Co., Ltd.).

<Mooney viscosity of resin that is solid at normal temperature and normal pressure>

The Mooney viscosity ($ML_{1+4}$, 100°C) of the resin that is solid at normal temperature and normal pressure was measured at 100°C in compliance with JIS-K6300 using a Mooney viscometer ("MOONEY VISCOMETER SMV-202" manufactured by Shimadzu Corporation). In general, the lower the Mooney viscosity of the resin that is solid at normal temperature and normal pressure, the higher the flexibility.

<Tack>

Tack to metal as an adherend of the heat conductive sheet was measured at 25°C using a probe tack tester ("TAC1000" manufactured by RHESCA Co., Ltd) as follows: A heat conductive sheet, punched into 4 mm diameter piece, was attached to the tip of a flat circular probe of 5 mm diameter using a double-sided adhesive tape, the probe was pressed against a nickel-plated copper plate (thickness: 2 mm, size = 3 cm × 3 cm) for 10 seconds under a pressure of 1.3 N (130 gf), and the force required to pull away the probe with the heat conductive sheet from the copper plate was measured. The measured value of tack to metal is an index of adhesion to metal. The larger the measured value of tack to metal, the better the adhesion to metal.

<Tensile strength>

The heat-conductive sheet was punched using a dumbbell No. 2 (dumbbell type, width: 3mm, length 70mm) in accordance with JIS K7113 to prepare 5 sample pieces. Using a tensile tester ("AG-IS20kN" manufactured by Shimadzu Corporation), tensile strength was measured under the following condition: load cell = 50N, chuck-to-chuck distance = 35 mm, velocity: 25 mm/ min, and temperature = 23°C.
The direction of punching was such that the long axis of the dumbbell intersects with strips constituting the heat conductive sheet at an angle of 90°. A total of the following 5 positions were punched: the sheet center and the four corners (the position where a part of the dumbbell falls within 3cm from the corner).

The average value of the measured values of the 5 sample pieces was taken as the tensile strength of the heat conductive sheet.

Heat transfer rate

Thermal diffusivity $\alpha$ (m$^2$/s), constant pressure specific heat Cp (J/g K, and specific gravity $\rho$ (g/m$^3$) of the heat conductive film were measured by the methods described below.

[Thermal diffusivity $\alpha$ in thickness direction]

Thermal diffusivity was measured at 25°C using a thermophysical property analyzer ("Thermo Wave Analyzer TA35" manufactured by BETHEL Co., Ltd.). A heat conductive sheet sliced in 0.3 mm thick was used for the measurement.

[Constant pressure specific heat Cp]

Specific heat at 25°C was measured using a differential scanning calorimeter ("DSC8230" manufactured by Rigaku Corporation) at a heating rate of 10°C/min.

[Specific gravity $\rho$ (density)]

Density was measured using an automated densimeter (DENSIMETER-H, TOYO SEIKI Co., Ltd.).
Each measured value was substituted into the following formula (I):

$$\lambda = \alpha \times Cp \times \rho \quad \cdots \quad (I)$$

to find heat transfer rate $\lambda$ (W/m·K) at 25°C in thickness direction of the heat conductive sheet.

<Orientation angle of particulate carbon material>

The orientation of graphite (particulate carbon material) in the heat conductive sheet was observed using a scanning electron microscope (SEM) (SU-3500, manufactured by Hitachi High-Technologies,) in a cross section obtained by cutting the heat conductive sheet into a regular octagon shape at a magnification that fits from the upper end to the lower end of the sheet. The magnification at this time was 700 times. 50 lines were drawn on the long axis of the graphite (particulate carbon material) in this cross section, and the average of the angles of the long axis with respect to the surface of the heat conductive sheet was calculated. When the angle was 90° or above, the supplementary angle was adopted. This was performed on eight surfaces, and the largest value among the eight surfaces was taken as the orientation angle of graphite (particulate carbon material) in the heat conductive sheet.

<Flame retardancy>

10 test pieces were prepared by cutting the heat conductive sheet into pieces each having a size of 125 mm length ×13 mm width. Five of them were stored for 48 hours in an environment of a temperature of 23°C and a relative humidity of 50% (storage I). The other five of them were stored at 70°C for 168 hours and subjected to aging treatment (II). In this way, two sets of five test pieces, each set subjected to two different treatments, were prepared.
The test pieces of each set were then vertically lifted one by one and supported by a fastening clamp, and cotton wool was placed about 300 mm below the supported specimens. A blue flame with a height of about 20 mm was created by adjusting the flow rates of air and gas of the Bunsen burner, so that a Bunsen burner flame was applied to the lower end of the vertically supported test piece (such that the flame and the test piece intersect with each other by about 10 mm) for 10 seconds. The Bunsen burner flame was then separated from the test piece. Once the flame on the test piece disappeared, the flame of the Bunsen burner was again immediately applied to the test piece, and after retaining this state for another 10 seconds, the test piece and the flame of the Bunsen burner were separated. Then, the residual flame time (time when the test piece burns with a flame) after the first flame contact, the residual flame time after the second flame contact, the second flameless combustion time (time where the test piece burns without a flame after removing the flame), whether or not the test piece ignites the cotton wool, and whether or not the test piece produces drops while causing a flame, were confirmed and evaluated.
Specifically, 2 sets of the 5 test pieces were tested whether they satisfy the following (1) to (4) conditions: (1) the residual flame time of both after the first flame contact and the second flame contact is within 10 seconds for each test piece, (2) the total of the residual flame time after the flame contact for 5 sheets is within 50 seconds, (3) no drip to ignite cotton wool occurs, and (4) the flameless combustion time after the second flame contact is within 30 seconds. It can be said that when every test piece subjected to 48-hour storage (I) and aging treatment (II) satisfies all of the above conditions (1) to (4), the heat conductive sheet is excellent in flame retardancy.

OK: All of the test pieces subjected 48-hour storage (I) and aging treatment (II) satisfy the above conditions (1) to (4).

Fail: At least one of the test specimens subjected to 48 storage (I) and the aging treatment (II) does not satisfy one or more of the above conditions (1) to (4) (out of the standards).

-: Unable to evaluate

(Example 1)

<Preparation of Composition>

75 parts of a thermoplastic fluororesin that is liquid at normal temperature and under normal pressure ("Diel G-101" manufactured by Daikin Industries, Ltd., viscosity (viscosity coefficient) = 3,300P) as a fluororesin, 25 parts of a hydroxyl group-containing liquid acrylic polymer having a weight average molecular weight of 6,000 ("ARUFON® UH-2190" (ARUFON is a registered trademark in Japan, other countries, or both) manufactured by TOAGOSEI Co., Ltd., viscosity = 34,000 mPa·s@25°C, glass transition temperature (Tg) = -47°C, hydroxyl value = 33 mg·KOH/g resin) as an acrylic resin, and 80 parts of expanded graphite ("EC-300" manufactured by Ito Graphite, Co., Ltd., volume-average particle diameter = 50 μm) as a heat conductive filler were stirred and mixed for 5 minutes using Hobart mixer ("ACM-5LVT type" manufactured by Kodaira Seisakusho Co., Ltd.). The resulting mixture was vacuum defoamed for 30 minutes to give a composition. The obtained composition was charged into a crusher and crushed for 10 seconds.

<Formation of pre-heat conductive sheet>

The crushed composition (1kg) was sandwiched between sandblasted PET films (protective films) having a thickness of 50 μm and rolled (primary pressing) at a roll gap of 550 μm, roll temperature of 50°C, roll linear pressure of 50 kg/cm, and roll speed of 1 m/min (primary pressing) to obtain a preheat conductive sheet having a thickness 0.5 mm.

<Formation of laminate>

Subsequently, the obtained pre-heat conductive sheet was cut into pieces with a size of 150 mm length × 150 mm width, 0.5mm thick. A total of 120 sheets were laminated in the thickness direction of the pre-heat conductive sheet and pressed in the lamination direction at 25°C for 3 minutes at a pressure 0.1MPa (secondary pressing) to obtain a laminate having a height of about 60 mm.

<Formation of heat conductive sheet>

Thereafter, while pressing the side surface of the laminate subjected to secondary pressing at a pressure of 0.3MPa, a slicer for woodworking (SUPER MECA S, manufactured by Marunaka Tekkosyo Inc.) was used to slice the laminate at an angle of 0° with respect to the lamination direction (in other words, in the normal direction of the main surface of the laminated pre-heat conductive sheets), a heat conductive sheet (having a configuration in which strips are joined in parallel) with a size of 150 mm length × 60 mm width × 0.15 mm thick was obtained.

The obtained heat conductive sheet was then measured and evaluated for tack to metal as an adherend, tensile strength, heat transfer rate, flame retardancy, and orientation angle of graphite (particulate carbon material) according to the above-described methods. The results are shown in Table 1.

(Example 2)

A composition, a pre-heat conductive sheet, a laminate, and a heat conductive sheet were produced in the same manner as in Example 1, except that the amount of the fluororesin used in Example 1 was changed to 50 parts and the amount of the acrylic polymer used in Example 1 was changed to 50 parts in the preparation of the composition.

Measurement and evaluation were carried out in the same way as in Example 1. The results are shown in Table 1.

(Example 3)

A composition, a pre-heat conductive sheet, a laminate, and a heat conductive sheet were produced in the same manner as in Example 1, except that the amount of the fluororesin used in Example 1 was changed to 90 parts and the amount of the acrylic polymer used in Example 1 was changed to 10 parts in the preparation of the composition.
Measurement and evaluation were carried out in the same way as in Example 1. The results are shown in Table 1.

(Example 4)

A composition, a pre-heat conductive sheet, a laminate, and a heat conductive sheet were produced in the same manner as in Example 1, except that the amount of the fluororesin used in Example 1 was changed to 25 parts and the amount of the acrylic polymer used in Example 1 was changed to 75 parts in the preparation of the composition.
Measurement and evaluation were carried out in the same way as in Example 1. The results are shown in Table 1.

(Example 5)

A composition, a pre-heat conductive sheet, a laminate, and a heat conductive sheet were produced in the same manner as in Example 1, except that in the preparation of the composition a hydroxyl group-containing liquid acrylic polymer having a weight-average molecular weight of 11,000 ("ARUFON® UH-2000" manufactured by TOAGOSEI Co., Ltd.), viscosity = 14,000 mPa·s@25°C, glass transition temperature (Tg)= -55°C, hydroxyl value = 20 mg·KOH/g resin) was used as the acrylic resin instead of the acrylic polymer used in Example 1.
Measurement and evaluation were carried out in the same way as in Example 1. The results are shown in Table 1.

(Example 6)

A composition, a pre-heat conductive sheet, a laminate, and a heat conductive sheet were produced in the same manner as in Example 1, except that, as the fluororesin, 20 parts of a thermoplastic fluororesin that is solid at normal temperature and normal pressure ("DYNEON FC2211" manufactured by 3M Japan Limited, Mooney viscosity = 27 $ML_{1+4}$, 100°C) and 55 parts of the thermoplastic fluororesin that is liquid at normal temperature and normal pressure used in Example 1 were stirred and mixed in the presence of 60 parts of ethyl acetate as a solvent, and ethyl acetate was removed simultaneously with vacuum defoaming.
Measurement and evaluation were carried out in the same way as in Example 1. The results are shown in Table 1.

(Example 7)

A composition, a pre-heat conductive sheet, a laminate, and a heat conductive sheet were produced in the same manner as in Example 4, except that, as the fluororesin, 20 parts of the thermoplastic fluororesin that is solid at normal temperature and normal pressure used in Example 6 and 40 parts of the thermoplastic fluororesin that is liquid at normal temperature and normal pressure used in Example 1, and, as the acrylic resin, 40 parts of the acrylic polymer used in Example 1 were used, stirring and mixing were performed in the presence of 60 parts of ethyl acetate as a solvent, and ethyl acetate was removed simultaneously with vacuum defoaming.
Measurement and evaluation were carried out in the same way as in Example 1. The results are shown in Table 1.

(Example 8)

A composition, a pre-heat conductive sheet, a laminate, and a heat conductive sheet were produced in the same manner as in Example 7, except that, in place of the acrylic polymer used in Example 7, a non-functional group-type liquid acrylic polymer having a weight average molecular weight of 2,300 ("ARUFON® UP-1110" manufactured by TOAGOSEI Co., Ltd., viscosity = 3,500 mPa·s@25°C, glass transition temperature (Tg)= -64°C) was used as the acrylic resin.
Measurement and evaluation were carried out in the same way as in Example 1. The results are shown in Table 1.

(Example 9)

A composition, a pre-heat conductive sheet, a laminate, and a heat conductive sheet were produced in the same manner as in Example 7, except that, in place of the acrylic polymer used in Example 7, a non-functional group-type liquid acrylic polymer having a weight average molecular weight of 1,700 ("ARUFON® UP-1190" manufactured by TOAGOSEI Co., Ltd., viscosity = 6,000 mPa·s@25°C, glass transition temperature (Tg)= -57°C) was used as the acrylic resin.

Measurement and evaluation were carried out in the same way as in Example 1. The results are shown in Table 1.

(Comparative Example 1)

A composition, a pre-heat conductive sheet, a laminate, and a heat conductive sheet were produced in the same manner as in Example 1, except that the amount of the fluororesin used in Example 1 was changed to 100 parts and no acrylic resin was added in the preparation of the composition.

Measurement and evaluation were carried out in the same way as in Example 1. The results are shown in Table 1.

(Comparative Example 2)

In the preparation of the composition, a composition, a pre-heat conductive sheet, a laminate, and a heat conductive sheet were produced in the same manner as in Example 1, except that an acrylic polymer having a weight-average molecular weight of 600,000 ("PARACRON ME-2000" manufactured by Negami Chemical Industrial Co., Ltd., glass transition temperature (Tg) = -35°C) was used as the acrylic resin instead of the acrylic polymer used in Example 1.

Measurement and evaluation were carried out in the same way as in Example 1. The results are shown in Table 1.

(Comparative Example 3)

A composition was prepared in the same manner as in Example 1, except that the amount of the acrylic polymer used in Example 1 was changed to 100 parts and no fluororesin was added. The viscosity of the composition was so high that the composition could not be crushed. Thus, a pre-heat conductive sheet, a laminate, and a heat conductive sheet were not produced.

(Comparative Example 4)

A composition was prepared in the same manner as in Example 1, except that, as the acrylic resin, 50 partw of the same acrylic polymer as that used in Example 1 ("ARUFON® UH-2190", manufactured by TOAGOSEI Co., Ltd.) and 50 parts of and the same acrylic polymer as that used in Comparative Example 2 ("PARACRON ME-2000" manufactured by Negami Chemical Industrial Co., Ltd., glass transition temperature (Tg) = -35 ° C.) were used and no fluororesin was used. The viscosity of the composition was so high that the composition could not be crushed. Thus, a pre-heat conductive sheet, a laminate, and a heat conductive sheet were not produced.

Table 1

| Section | Component | | Average molecular weight | Viscosity mPa s/25°C | Ex. 1 | Ex. 2 | Ex. 3 | Ex. 4 | Ex. 5 | Ex. 6 | Ex. 7 | Ex. 8 | Ex. 9 | Comp. 1 | Comp. 2 | Comp. 3 | Comp. 4 |
|---|---|---|---|---|---|---|---|---|---|---|---|---|---|---|---|---|---|
| **Composition** | Solid fluororesin | | | | | | | | | 20 | 20 | 20 | 20 | 100 | | | |
| | Liquid fluororesin | 1. UH-2190 | 6000 | 34000 | 75 | 50 | 90 | 25 | | 55 | 40 | | | | 75 | 100 | 50 |
| | | 2. UH-2000 | 11000 | 14000 | | | | | 75 | | | | | | | | |
| | | 3. UP-1110 | 2300 | 3500 | | | | | | | | 40 | | | | | |
| | | 4. UP-1190 | 1700 | 6000 | | | | | | | | | 40 | | | | |
| | Acrylic polymer | 5. PARACRON | 600000 | - | 25 | 50 | 10 | 75 | 25 | 25 | 40 | 40 | 40 | | 25 | | 50 |
| | Graphite | EC-300 | | | 80 | 80 | 80 | 80 | 80 | 80 | 80 | 80 | 80 | 80 | 80 | 80 | 80 |
| **Evaluations** | Tack (adherend: copper) N/cm² | | | | 51 | 55 | 23 | 60 | 45 | 27 | 37 | 40 | 37 | 15 | 18 | Could not be produced[note] | Could not be produced[note] |
| | Tensile strength MPa | | | | 0.10 | 0.08 | 0.11 | 0.03 | 0.10 | 0.53 | 0.20 | 0.11 | 0.17 | 0.11 | 2.15 | - | - |
| | Heat transfer rate W/mK | | | | 23 | 18 | 22 | 18 | 22 | 24 | 23 | 21 | 22 | 22 | 22 | - | - |
| | Orientation angle of graphite | | | | 81 | 78 | 82 | 78 | 84 | 85 | 84 | 82 | 85 | 82 | 85 | - | - |
| | Flame retardancy | | | | OK | OK | OK | OK | OK | OK | OK | OK | OK | OK | OK | - | - |

(Notes in Table)

Preparation was discontinued because the viscosity of the composition was high that crushing was not possible.

Table 1 shows that heat conductive sheets containing a fluororesin, an acrylic resin having a weight average molecular weight of 20,000 or less, and a heat conductive filler were good in flame retardancy, thermal conductivity using heat transfer rate as an index, and durability using tensile strength as an index, and were excellent in adhesion to metal using tack to metal as an index.

INDUSTRIAL APPLICABILITY

According to the present disclosure, it is possible to provide a heat conductive sheet excellent in adhesion to metal and flame retardancy.

**Claims**

1.  A heat conductive sheet, comprising a fluororesin, an acrylic resin having a weight average molecular weight of 20,000 or less, and a heat conductive filler.

2.  The heat conductive sheet according to claim 1, wherein the fluororesin includes a fluororesin that is liquid at normal temperature and normal pressure.

3.  The heat conductive sheet according to claim 2, wherein the fluororesin includes both a fluororesin that is liquid at normal temperature and normal pressure and a fluororesin that is solid at normal temperature and normal pressure.

4.  The heat conductive sheet according to any one of claims 1 to 3, wherein the acrylic resin has a weight average molecular weight of 10,000 or less.

5.  The heat conductive sheet according to any one of claims 1 to 4, wherein the acrylic resin includes an acrylic resin that is liquid at normal temperature and normal pressure.

6.  The heat conductive sheet according to any one of claims 1 to 5, wherein the acrylic resin includes a hydroxyl group.

7.  The heat conductive sheet according to any one of claims 1 to 6, wherein a content of the acrylic resin is 20% by mass or more and 70% by mass or less in the total resin.

8.  The heat conductive sheet according to any one of claims 1 to 7, wherein the heat conducive sheet is composed of strips joined together in parallel, each strip made of a composition in which the fluororesin, the acrylic resin, and the heat conductive filler are mixed.

## INTERNATIONAL SEARCH REPORT

| International application No. |
| --- |
| **PCT/JP2022/043066** |

**A.    CLASSIFICATION OF SUBJECT MATTER**

*H01L 23/373*(2006.01)i; *C08L 27/12*(2006.01)i; *C08L 33/06*(2006.01)i; *C08J 5/18*(2006.01)i; *C09K 5/10*(2006.01)i; *C08K 3/013*(2018.01)i; *H05K 7/20*(2006.01)i
FI:    H01L23/36 M; C08K3/013; C08L33/06; C09K5/10 E; H05K7/20 F; C08J5/18 CEY; C08L27/12

According to International Patent Classification (IPC) or to both national classification and IPC

**B.    FIELDS SEARCHED**

Minimum documentation searched (classification system followed by classification symbols)

H01L23/373; C08L27/12; C08L33/06; C08J5/18; C09K5/10; C08K3/013; H05K7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | JP 2021-513503 A (TUNGHSU TECHNOLOGY GROUP CO., LTD.) 27 May 2021 (2021-05-27) paragraphs [0009], [0019], [0029], [0100]-[0155], [0274]-[0382] | 1, 4, 6 |
| Y | | 2, 3, 5, 8 |
| A | | 7 |
| Y | JP 2018-129377 A (NIPPON ZEON CO., LTD.) 16 August 2018 (2018-08-16) paragraphs [0018]-[0029], [0051]-[0055] | 2, 3, 5, 8 |
| A | JP 2021-158274 A (NIPPON ZEON CO., LTD.) 07 October 2021 (2021-10-07) paragraph [0062] | 1-8 |
| A | JP 2020-76029 A (NIPPON ZEON CO., LTD.) 21 May 2020 (2020-05-21) entire text | 1-8 |

☐ Further documents are listed in the continuation of Box C.          ☑ See patent family annex.

| | |
| --- | --- |
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **30 January 2023** | **14 February 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/043066**

| Patent document cited in search report | | | Publication date (day/month/year) | Patent family member(s) | | | Publication date (day/month/year) |
|---|---|---|---|---|---|---|---|
| JP | 2021-513503 | A | 27 May 2021 | US | 2021/0017436 | A1 | |
| | | | | paragraphs [0009], [0019], [0028], [0029], [0048], [0145]-[0200], [0312]-[0414] | | | |
| | | | | WO | 2019/153842 | A1 | |
| | | | | CN | 108373592 | A | |
| | | | | KR | 10-2020-0118475 | A | |
| JP | 2018-129377 | A | 16 August 2018 | US | 2018/0223147 | A1 | |
| | | | | paragraphs [0029]-[0053], [0102]-[0114] | | | |
| | | | | JP | 2021-158364 | A | |
| JP | 2021-158274 | A | 07 October 2021 | (Family: none) | | | |
| JP | 2020-76029 | A | 21 May 2020 | (Family: none) | | | |

Form PCT/ISA/210 (patent family annex) (January 2015)

**EP 4 443 493 A1**

**Patent documents cited in the description**

- WO 2017145954 A
- WO 2006011655 A
- WO 2016185688 A